# EUROPÄISCHE PATENTANMELDUNG

(11) **EP 4 224 127 A1**
(43) Veröffentlichungstag der Anmeldung: **09.08.2023**
(21) Anmeldenummer: 23154367.9
(22) Anmeldetag: 01.02.2023
(51) Int. Cl.: G01K 1/14, G01K 7/22

(54) **TEMPERATURSENSOR FÜR EINEN INVERTER ZUM BETREIBEN EINES ELEKTRISCHEN ANTRIEBS IN EINEM ELEKTROFAHRZEUG ODER EINEM HYBRIDFAHRZEUG, INVERTER MIT EINEM SOLCHEN TEMPERATURSENSOR**

(30) Priorität: 04.02.2022 DE 102022201176
(71) Anmelder: ZF Friedrichshafen AG, 88046 Friedrichshafen (DE); Interplex NAS Electronics GmbH, 74078 Heilbronn (DE)
(72) Erfinder: Wang, Pengshuai, 88097 Eriskirch (DE); Kohr, Michael, 88285 Bodnegg (DE); Rau, Philipp, 88045 Friedrichshafen (DE); Hahn, Hans-Joerg, 74078 Heilbronn (DE)

(57) **Zusammenfassung**

Temperatursensor (10) für einen Inverter zum Betreiben eines elektrischen Antriebs in einem Elektrofahrzeug oder einem Hybridfahrzeug, umfassend zumindest einen stabförmigen Signalanschluss (12A, 12B), einen Träger (14) und eine Sensorleiterplatte (16), wobei im Träger (14) zumindest eine Rille (142) zum Anordnen des zumindest einen stabförmigen Signalanschlusses (12A, 12B) ausgebildet ist, wobei der zumindest eine stabförmige Signalanschluss (12A, 12B) ein Steckteil (122) zum Einstecken in eine Leiterplatte (18) des Inverters aufweist, wobei das Steckteil (122) über einen der Leiterplatte (18) zugewandten oberen Rand (144) des Trägers (14) hinausragt, wobei sich der zumindest eine stabförmige Signalanschluss (12A, 12B) vom Steckteil (122) über einen von der Leiterplatte (18) abgewandten unteren Rand (146) des Trägers (14) hinausragt, wobei ein Sensorelement (162) zur Temperaturerfassung an einem von der Leiterplatte (18) abgewandten Ende (164) der Sensorleiterplatte (16) angebracht ist.

## Beschreibung

Die Erfindung betrifft einen Temperatursensor, der in einem Inverter zum Betreiben eines elektrischen Antriebs eines Elektrofahrzeugs oder eines Hybridfahrzeugs eingebaut ist, sowie einen entsprechenden Inverter.

Im Stand der Technik sind reine Elektrofahrzeuge sowie Hybridfahrzeuge bekannt, welche ausschließlich bzw. unterstützend von einer oder mehreren elektrischen Maschinen als Antriebsaggregate angetrieben werden. Um die elektrischen Maschinen solcher Elektrofahrzeuge bzw. Hybridfahrzeuge mit elektrischer Energie zu versorgen, umfassen die Elektrofahrzeuge und Hybridfahrzeuge elektrische Energiespeicher, insbesondere wiederaufladbare elektrische Batterien. Diese Batterien sind dabei als Gleichspannungsquellen ausgebildet, die elektrischen Maschinen benötigen in der Regel jedoch eine Wechselspannung. Daher wird zwischen einer Batterie und einer elektrischen Maschine eines Elektrofahrzeugs oder eines Hybridfahrzeugs üblicherweise eine Leistungselektronik mit einem sog. Inverter geschaltet.

Derartige Inverter umfassen üblicherweise Halbleiterschaltelemente, die typischerweise aus Transistoren gebildet sind. Dabei ist es bekannt, die Halbleiterschaltelemente in unterschiedlichen Integrationsgraden bereitzustellen, nämlich entweder als diskrete Einzelschalter mit einem geringen Integrationsgrad, jedoch hoher Skalierbarkeit, als Leistungsmodule mit einem hohen Integrationsgrad, jedoch geringer Skalierbarkeit, sowie als Halbbrücken, die hinsichtlich Integrationsgrad und Skalierbarkeit zwischen Einzelschaltern und Halbbrücken rangieren. Jede Halbbrücke umfasst eine Highside-Schaltposition (nachfolgend: "Highside") mit einem höheren elektrischen Potential und eine Lowside-Schaltposition (nachfolgend: "Lowside") mit einem niedrigeren elektrischen Potential. Die Highside und die Lowside können jeweils einen oder mehrere Einzelschalter/Halbleiterschaltelemente umfassen, die parallelgeschaltet sind.

In jeder Halbbrücke sind mehrere Leistungsanschlüsse angeordnet, mittels derer DC-Eingangsströme in die Halbleiterschaltelemente eingespeist und AC-Ausgangsströme von den Halbleiterschaltelementen abgegriffen werden können. In jeder Halbbrücke sind ferner mehrere Signalanschlüsse zur Übertragung von Steuersignalen, insbesondere Gate-Signalen, vorgesehen, mittels derer die Halbleiterschaltelemente gezielt geschaltet werden, um einen Laststrom durch das jeweilige Halbleiterschaltelement durchzulassen beziehungsweise zu sperren. Auf diese Weise kann ein Stromfluss zwischen den einzelnen Leistungsanschlüssen ermöglicht bzw. verhindert werden. Eine Ansteuerelektronik umfassend eine Leiterplatte und eine Vielzahl elektronischer Bauteile, die auf der Leiterplatte angebracht sind, dient zur Erzeugung der Steuersignale.

Für den Betrieb des Inverters ist wichtig, dass die Halbleiterschaltelemente ihre maximale Betriebstemperatur nicht überschreiten. Um dies zu gewährleisten, werden bei den aus dem Stand der Technik bekannten Invertern Temperatursensoren eingesetzt, um die Temperatur der Halbleiterschaltelemente näherungsweise zu erfassen. Dennoch ist die Montierung der bisherigen Temperatursensoren bauartbedingt aufwendig. Außerdem erfordern die bisherigen Temperatursensoren einen vergleichsweise großen Bauraum, um zusätzliche Bauteile zur Stabilisierung der Temperatursensoren beim Einmontieren unterzubringen.

Es ist eine Aufgabe der Erfindung, einen Temperatursensor für einen Inverter zum Betreiben eines elektrischen Antriebs für ein Elektro- oder Hybridfahrzeug bereitzustellen, bei dem die vorstehend genannten Nachteile zumindest teilweise überwunden sind.

Diese Aufgabe wird erfindungsgemäß durch den Temperatursensor und den Inverter gemäß den unabhängigen Patentansprüchen gelöst. Vorteilhafte Ausgestaltungen und Weiterbildungen der Erfindung gehen aus den abhängigen Patentansprüchen hervor.

Die Erfindung betrifft einen Temperatursensor, der in einem Inverter für einen elektrischen Antrieb eines Elektrofahrzeugs oder eines Hybridfahrzeugs eingebaut ist.

Der Temperatursensor umfasst zumindest einen stabförmigen Signalanschluss, vorzugsweise zwei oder mehrere stabförmige Signalanschlüsse. Die stabförmigen Signalanschlüsse können entlang der Längsrichtung einen kreisförmigen, einen viereckig oder einen anderen Querschnitt aufweisen. Der Temperatursensor umfasst einen Träger, der vorzugsweise aus einem Kunststoff gebildet ist. Der Träger weist zumindest eine Rille zum Einführen des zumindest einen stabförmigen Signalanschlusses auf, wobei vorzugsweise die gleiche Anzahl an Rillen wie die stabförmigen Signalanschlüsse im Träger ausgebildet sind. Die Rillen sind vorzugsweise derart ausgebildet, dass die stabförmigen Signalanschlüsse in den Rillen form- und/oder kraftschlüssig aufgenommen sind.

Der eine stabförmige Signalanschluss bzw. die stabförmigen Signalanschlüsse weisen jeweils ein Steckteil zum Einstecken in eine Leiterplatte des Inverters auf. Dazu weist die Leiterplatte eine bzw. mehrere Öffnungen zur kraft- und/oder formschlüssigen Aufnahme der Steckteile auf. Das Steckteil ragt über einen der Leiterplatte zugewandten oberen Rand des Trägers hinaus und kann in die entsprechende Öffnung der Leiterplatte eingesteckt werden. Der zumindest eine stabförmige Signalanschluss ragt unterseitig über einen von der Leiterplatte abgewandten, dem oberen Rand gegenüberliegenden unteren Rand des Trägers hinaus. Vorzugsweise ragen mehrere, weiter vorzugsweise alle, stabförmigen Signalanschlüsse über den unteren Rand des Trägers hinaus. Ein Sensorelement zur Temperaturerfassung ist an einem von der Leiterplatte abgewandten Ende der Sensorleiterplatte angebracht. Das Sensorelement kann auf einem Material mit einem negativen Temperaturkoeffizienten (NTC) oder einem positiven Temperaturkoeffizienten (PTC) basieren.

Mit dieser Maßnahme kann der Temperatursensor beim Einstecken in die Leiterplatte von unten in Richtung der Leiterplatte besonders einfach mit Presskraft beaufschlagt werden, ohne den Aufbau des Temperatursensors zu beeinträchtigen. Insbesondere kann das jeweilige Steckteil des Temperatursensors hierdurch unter vergleichsweise hohen Presskraftbeaufschlagung in die Leiterplatte eingesteckt werden, sodass eine sichere Fixierung des Temperatursensors an der Leiterplatte gewährleistet ist. Auch kann auf ein zusätzliches Sicherungselement zur Stabilisierung des Temperatursensors beim Einstecken in die Leiterplatte verzichtet werden, sodass zusätzlicher Bauraum hierdurch gewonnen wird.

Gemäß einer Ausführungsform ist die Sensorleiterplatte zwischen zwei Längswänden des Trägers eingesetzt, wobei der Abstand zwischen den Längswänden der Breite der Sensorleiterplatte im Wesentlichen entspricht. Die Sensorleiterplatte ist daher als Deckel zum Verschließen einer zwischen den Längswänden ausgebildeten Lücke ausgebildet ist, sodass sich der zumindest eine stabförmige Signalanschluss zwischen dem Träger und dem Deckel (bzw. der Sensorleiterplatte) befindet. Dadurch, dass der Abstand zwischen den Längswänden der Breite der Sensorleiterplatte entspricht, ist eine Drehbewegung der Sensorleiterplatte relativ zum Träger im aufgenommenen Zustand verringert oder gar verhindert werden. Dies ermöglicht eine sichere Aufnahme der Sensorleiterplatte im Träger.

Gemäß einer weiteren Ausführung weist der Träger ein Zentrierelement auf, das sich von einer die Sensorleiterplatte in einem eingesetzten Zustand beaufschlagenden Kontaktfläche heraus in eine in der Sensorleiterplatte ausgebildete Aufnahme hineinragt. Das Zentrierelement kann einen kreisförmigen oder einen rechteckigen Querschnitt in der Richtung parallel zur Sensorleiterplatte aufweisen. Mit dieser Maßnahme kann eine Verschiebung und/oder eine Drehbewegung der Sensorleiterplatte relativ zum Träger verringert oder gar verhindert werden. Die in der Sensorleiterplatte ausgebildete Aufnahme kann ein Sackloch oder eine Durchgangsloch aufweisen.

Gemäß einer weiteren Ausführung ist der Träger als Spritzgussbauteil mittels Umspritzens des zumindest einen stabförmigen Signalanschlusses ausgebildet. Der Temperatursensor ist hierdurch mit reduziertem Aufwand herstellbar. Außerdem ist die Materialhaftung zwischen dem Träger und dem zumindest einen stabförmigen Signalanschluss besonders stabil. Alternativ ist der Träger als vorgefertigtes Bauteil ausgebildet, wobei der zumindest eine stabförmige Signalanschluss durch Einstecken in die Rille am Träger festgelegt ist.

Gemäß einer weiteren Ausführung ist das von der Leiterplatte abgewandte Ende der Sensorleiterplatte an einen Kühlkörper oder eine Vergussmasse des Inverters angebunden. Vorzugsweise dringt das von der Leiterplatte abgewandte Ende der Sensorleiterplatte derart in eine der Leiterplatte gegenüberliegende Oberfläche des Kühlkörpers, eines mit dem Kühlköper thermisch (etwa mit Hilfe eines zusätzlichen Wärmeleitelementes) gekoppelten Zwischenkörpers oder der Vergussmasse ein, dass das Sensorelement im Kühlkörper oder in der Vergussmasse aufgenommen ist. Auf diese Weise befindet sich das Sensorelement im einmontierten Zustand des Temperatursensors in der Nähe der Halbleiterschaltelemente, sodass die Betriebstemperatur der Halbleiterschaltelemente mit erhöhter Genauigkeit erfassbar ist. Alternativ ist das von der Leiterplatte abgewandte Ende der Sensorleiterplatte derart an eine der Leiterplatte gegenüberliegenden Oberfläche des Kühlkörpers oder der Vergussmasse derart angebunden, dass das Sensorelement außerhalb des Kühlkörpers oder der Vergussmasse angeordnet ist.

Die Erfindung betrifft weiterhin einen Inverter für einen elektrischen Antrieb eines Elektrofahrzeugs oder eines Hybridfahrzeugs mit einem erfindungsgemäßen Temperatursensor. Daraus ergeben sich die bereits im Zusammenhang mit der erfindungsgemäßen Halbbrücke beschriebenen Vorteile auch für den erfindungsgemäßen Inverter.

Der Inverter umfasst mehrere Halbleiterschaltelemente, ein Substrat, einen Kühlkörper und eine Leiterplatte. Das Substrat ist vorzugsweise ein mehrschichtiges Substrat, etwa ein Direct-Bonding-Copper (DBC-)Substrat mit einer ersten Metalllage, einer zweiten Metalllage und einer dazwischen angeordneten Isolationslage. Die Halbleiterschaltelemente sind auf dem Substrat, vorzugsweise auf der ersten Metalllage, angebracht. Das Substrat ist zwecks Entwärmung der Halbleiterschaltelemente an den Kühlkörper angebunden. Vorzugsweise ist die zweite Metalllage an eine Oberseite des Kühlkörpers angebunden. Die Leiterplatte weist elektronische Bauteile zur Ansteuerung der Halbleiterschaltelemente auf, wobei der Temperatursensor an der Leiterplatte befestigt ist.

Nachfolgend wird die Erfindung anhand von in den Figuren dargestellten Ausführungsformen beispielhaft erläutert.

Es zeigen:
- Fig. 1: eine schematische Ansicht eines Temperatursensors gemäß einer Ausführungsform;
- Fig. 2: eine weitere schematische Ansicht des Temperatursensors aus Fig. 1;
- Fig. 3: eine schematische Ansicht eines Trägers des Temperatursensors aus Fig. 1, wobei zwei stabförmige Signalanschlüsse im Träger eingesetzt sind;
- Fig. 4: eine schematische Ansicht des Trägers aus Fig. 3;
- Fig. 5: eine schematische Ansicht einer Sensorleiterplatte des Temperatursensors aus Fig. 1;
- Fig. 6: eine schematische Ansicht des Temperatursensors aus Fig. 1, der zwischen einer Leiterplatte und einem Kühlkörper eines Inverters montiert ist;
- Fig. 7: eine weitere schematische Ansicht des Temperatursensors aus Fig. 6, wobei der Temperatursensor unterseitig ins Innere des Kühlkörpers eindringt;
- Fig. 8: eine weitere schematische Ansicht des Temperatursensors aus Fig. 6, wobei der Temperatursensor unterseitig an eine Oberfläche des Kühlkörpers angebunden ist.

Gleiche Gegenstände, Funktionseinheiten und vergleichbare Komponenten sind figurenübergreifend mit den gleichen Bezugszeichen bezeichnet. Diese Gegenstände, Funktionseinheiten und vergleichbaren Komponenten sind hinsichtlich ihrer technischen Merkmale identisch ausgeführt, sofern sich aus der Beschreibung nicht explizit oder implizit etwas anderes ergibt.

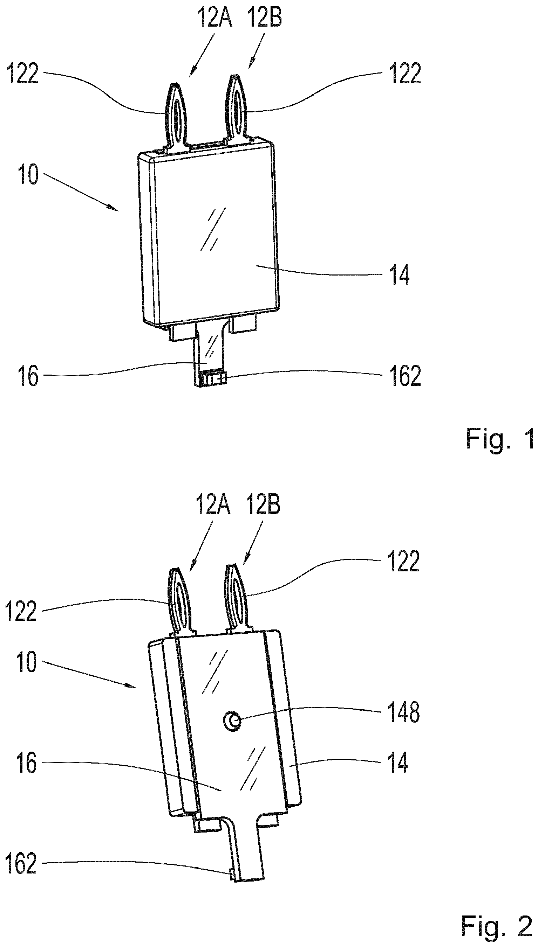

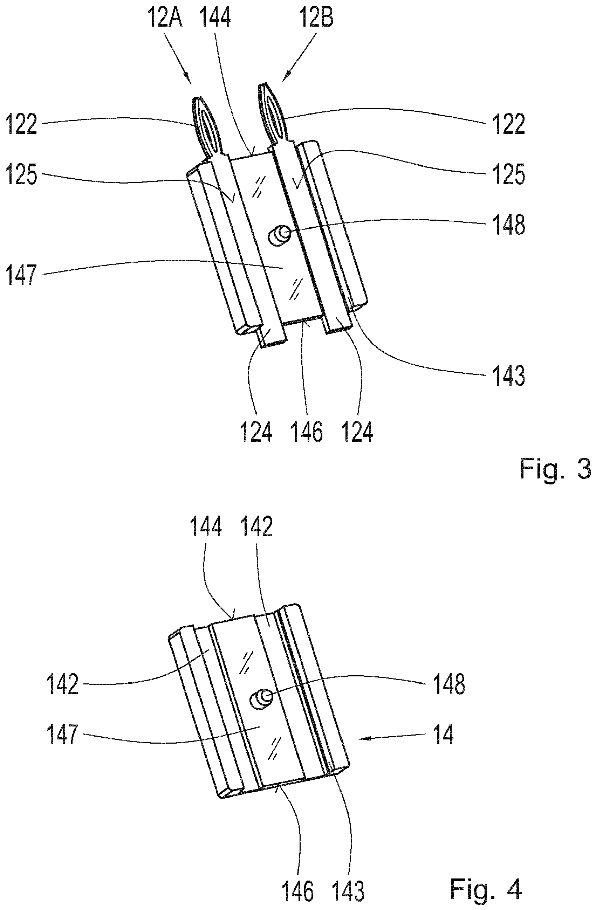

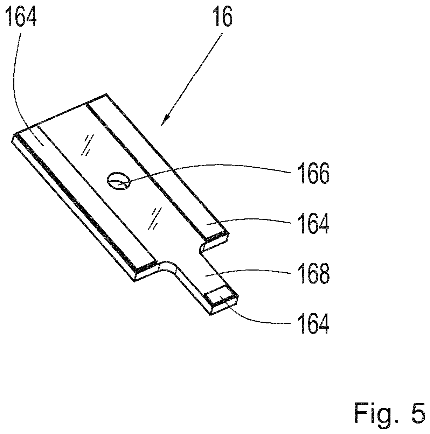

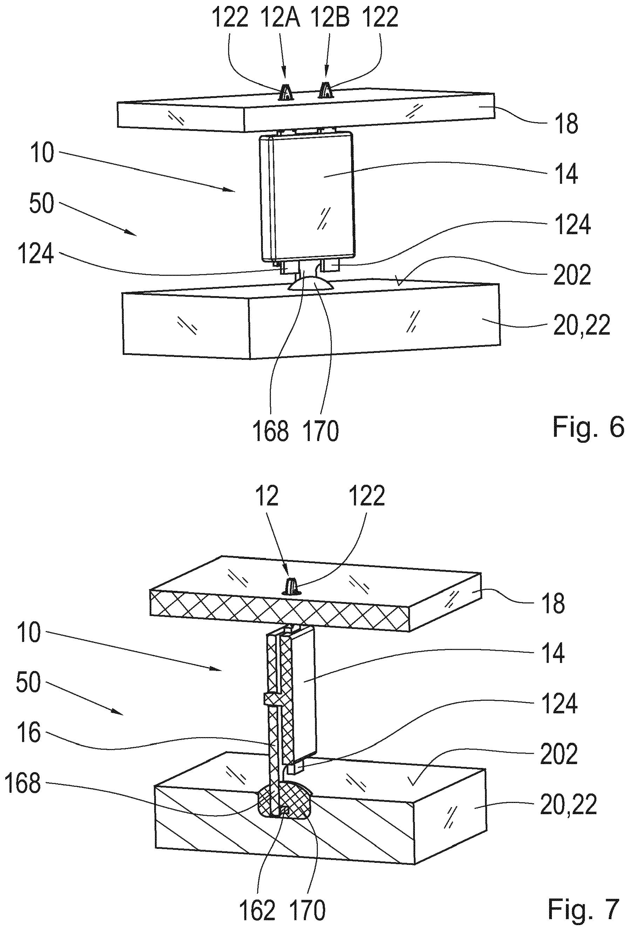

Fig. 1-2 zeigen jeweils schematisch einen Temperatursensor 10 für einen Inverter (DC/AC-Wechselrichter), der zum Bestromen eines elektrischen Antriebs in einem Elektrofahrzeug und/oder einem Hybridfahrzeug eingesetzt wird. Der Temperatursensor 10 ist mehrteilig ausgebildet und umfasst zumindest einen stabförmigen Signalanschluss 12 (siehe Fig. 7-8), hier beispielshaft zwei stabförmige Signalanschlüsse 12A, 12B, einen Träger 14 sowie eine Sensorleiterplatte 16. Der Träger 14 ist flach ausgebildet und weist, wie in Fig. 4 näher gezeigt, zwei in einer Längsrichtung verlaufende Rillen 142 auf, die parallel nebeneinander angeordnet sind. Die Rillen 142 erstrecken sich, wie in Fig. 4 schematisch gezeigt, vorzugsweise über die gesamte Länge des Trägers 14 hindurch. Die beiden stabförmigen Signalanschlüsse 12A, 12B sind in den Rillen 142 formschlüssig eingesetzt und weisen jeweils ein Steckteil 122 und ein Fußteil 124 auf. Das Steckteil 122 ragt über einen oberen Rand 144 des Trägers 14 hinaus. Das Fußteil 124 ragt über einen unteren Rand 146 des Trägers 14 hinaus. Fig. 3 zeigt den Träger 14 in einer schematischen Darstellung, wobei die stabförmigen Signalanschlüsse 12A, 12B im Träger 14 eingesetzt und festgelegt sind. Der Träger 14 weist ferner ein Zentrierelement 148 auf, das im Wesentlichen im Zentrum einer Innenfläche 147 des Trägers 14 angeordnet ist und aus der Innenfläche 147 herausschaut. Die Sensorleiterplatte 16 ist als Deckel zwischen zwei seitlichen Längswänden 143 des Trägers 14 angeordnet. Die Sensorleiterplatte 16 weist, wie in Fig. 5 schematisch gezeigt, zwei in der Längsrichtung verlaufende Verbindungsstreifen 164 auf, die jeweils mit einer von den Rillen 142 abgewandten Vorderfläche 125 der jeweiligen stabförmigen Signalanschlüsse 12A, 12B verbindbar sind. Im einmontierten Zustand der Sensorleiterplatte 16 tritt das Zentrierelement 148 durch eine mittig der Sensorleiterplatte 16 ausgebildete Öffnung 166 hindurch. Die Breite der Sensorleiterplatte 16 entspricht im Wesentlichen dem Abstand zwischen den beiden seitlichen Längswänden 142 des Trägers 14. Auf diese Weise ist eine Rotationsbewegung und eine translatorische Bewegung der Sensorleiterplatte 16 relativ zum Träger 14 reduziert oder gar verhindert, sodass die Sensorleiterplatte 16 besonders sicher und stabil am Träger 14 festgelegt ist.

Ein Sensorelement 162 zur Temperaturerfassung ist in einem Endabschnitt 168, vorzugsweise an einem untersten Rand, der Sensorleiterplatte 16 angebracht. Es handelt sich um ein NTC- oder PTC-Temperatursensorelement. Um eine möglichst genaue Temperaturerfassung zu erzielen, wird der Temperatursensor 10 gemäß den in Fig. 6-8 schematisch gezeigten Ausführungsformen derart im Inverter 50 zwischen einer Leiterplatte 18 und einem Kühlkörper 20 (bzw. einem mit diesem thermisch gekoppelten Zwischenkörper) oder einer Vergussmasse 22 angeordnet, dass sich das Sensorelement 162 möglichst nah an den im Inverter verbauten Halbleiterschaltelementen (nicht gezeigt) befindet.

Der Inverter 50 umfasst mehrere Halbleiterschaltelemente (nicht gezeigt), ein Substrat (nicht gezeigt), einen Kühlkörper 20 und eine Leiterplatte 18. In Fig. 6-8 ist der Einfachheit halber nur jeweils entweder der Kühlkörper 20 oder eine Vergussmasse 22, mit der das Substrat und die Halbleiterschaltelemente in einem Spritzgussverfahren vergossen worden sind, schematisch gezeigt. Die Halbleiterschaltelemente sind auf dem Substrat angebracht, das zwecks Entwärmung der Halbleiterschaltelemente an den Kühlkörper 20 angebunden ist. Die Leiterplatte 18 weist elektronische Bauteile zur Ansteuerung der Halbleiterschaltelemente auf.

In der in Fig. 6 schematisch gezeigten Ausführungsform werden zum Einmontieren des Temperatursensors 10 in den Inverter 50 die Steckteile 122 der stabförmigen Signalanschlüsse 12A, 12B durch zwei in der Leiterplatte 18 ausgebildete zugehörige Stecköffnungen eingepresst. Die Steckteile 122 weisen eine Doppelbogenform auf, bei der zwei Bogenseiten an ihren beiden Enden miteinander verbunden sind und ein Loch dazwischen einschließen. Beim Einpressen durch die Stecköffnungen der Leiterplatte 18 werden die doppelbogenförmigen Steckteile 122 komprimiert und leicht verspannt, sodass die Steckteile 122 aufgrund der Verspannung fest gegen die Innenwand der Stecköffnungen drücken und somit in der Leiterplatte 18 festgelegt sind. Fußseitig des Temperatursensors 10 befindet sich der Endabschnitt 168 der Sensorleiterplatte 16 teilweise im Kühlkörper 20/Zwischenkörper bzw. in der Vergussmasse 22. Ein Verbindungsmittel 170, welches vorzugsweise ein Versieglungsmittel oder Wärmeleitmittel ist, wird zum Fixieren des fußseitigen Endabschnittes 168 der Sensorleiterplatte 16 verwendet.

Fig. 7 zeigt schematisch eine Ausführungsform, bei der der Temperatursensor 10 beispielhaft nur über einen einzigen stabförmigen Signalanschluss 12 verfügt. Analog zur in Fig. 6 gezeigten Ausführungsform wird zunächst der stabförmige Signalanschluss 12 mit seinem kopfseitigen Steckteil 122 in die Stecköffnung der Leiterplatte 18 eingesteckt. Der Endabschnitt 168 der Sensorleiterplatte 18 wird danach ins Innere des Kühlkörpers 20/Zwischenkörper bzw. der Vergussmasse 22 eingebracht, indem zunächst eine Ausnehmung auf einer der Leiterplatte 18 gegenüberliegenden Oberfläche 202 des Kühlkörpers 20 bzw. der Vergussmasse 22 ausgebildet wird, sodass der Endabschnitt 168 zusammen mit dem Sensorelement 162 in die Ausnehmung eingetaucht werden kann. Im eingetauchten Zustand wird die Ausnehmung mit dem Verbindungs- bzw. Versieglungsmittel, etwa ein Schmiermittel oder eine Kunststoffmittel, befüllt.

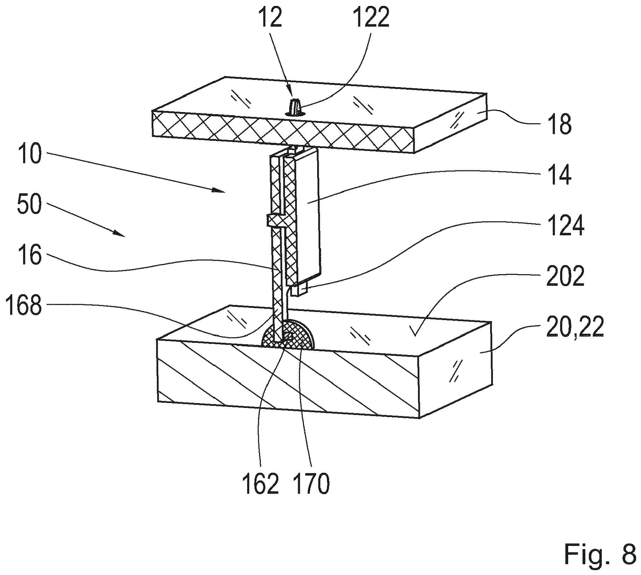

In der Ausführungsform von Fig. 8, bei der der Temperatursensor 10 ebenfalls beispielhaft nur über einen einzigen stabförmigen Signalanschluss 12 verfügt, wird analog zur in Fig. 6 gezeigten Ausführungsform zunächst der stabförmige Signalanschluss 12 mit seinem kopfseitigen Steckteil 122 in die Stecköffnung der Leiterplatte 18 eingesteckt. Der Endabschnitt 168 der Sensorleiterplatte 18 wird danach an die Oberfläche 202 des Kühlkörpers 20/Zwischenkörper bzw. der Vergussmasse 22 mit Hilfe des Verbindungs- bzw. Versieglungsmittels angebunden.

### Bezugszeichen

- 10: Temperatursensor
- 12, 12A,B: stabförmiger Signalanschluss
- 122: Steckteil
- 124: Fußteil
- 125: Vorderfläche
- 14: Träger
- 142: Rille
- 143: Längswand
- 144: oberer Rand
- 146: unterer Rand
- 147: Innenfläche
- 148: Zentrierelement
- 16: Sensorleiterplatte
- 162: Sensorelement
- 164: Verbindungsmittel
- 166: Öffnung
- 168: Endabschnitt
- 170: Verbindungsmittel
- 18: Leiterplatte
- 20: Kühlkörper
- 202: Oberfläche
- 22: Vergussmasse

## Patentansprüche

1. Temperatursensor (10) für einen Inverter zum Betreiben eines elektrischen Antriebs in einem Elektrofahrzeug oder einem Hybridfahrzeug, umfassend zumindest einen stabförmigen Signalanschluss (12A, 12B), einen Träger (14) und eine Sensorleiterplatte (16), wobei im Träger (14) zumindest eine Rille (142) zum Anordnen des zumindest einen stabförmigen Signalanschlusses (12A, 12B) ausgebildet ist, wobei der zumindest eine stabförmige Signalanschluss (12A, 12B) ein Steckteil (122) zum Einstecken in eine Leiterplatte (18) des Inverters aufweist, wobei das Steckteil (122) über einen der Leiterplatte (18) zugewandten oberen Rand (144) des Trägers (14) hinausragt, wobei der zumindest eine stabförmige Signalanschluss (12A, 12B) unterseitig über einen von der Leiterplatte (18) abgewandten unteren Rand (146) des Trägers (14) hinausragt, wobei ein Sensorelement (162) zur Temperaturerfassung an einem von der Leiterplatte (18) abgewandten Ende (164) der Sensorleiterplatte (16) angebracht ist.

2. Temperatursensor (10) nach Anspruch 1, wobei die Sensorleiterplatte (16) zwischen zwei Längswänden (143) des Trägers (14) eingesetzt ist, wobei der Abstand zwischen den Längswänden (143) der Breite der Sensorleiterplatte (16) im Wesentlichen entspricht.

3. Temperatursensor (10) nach Anspruch 1 oder 2, wobei der Träger (14) ein Zentrierelement (148) aufweist, das sich von einer die Sensorleiterplatte (16) in einem eingesetzten Zustand beaufschlagenden Kontaktfläche (150) heraus in eine in der Sensorleiterplatte (16) ausgebildete Aufnahme hineinragt.

4. Temperatursensor (10) nach Anspruch 3, wobei die Aufnahme ein Sackloch oder eine Durchgangsloch (166) aufweist.

5. Temperatursensor (10) nach einem der Ansprüche 1 bis 4, wobei der Träger (14) als Spritzgussbauteil mittels Umspritzens des zumindest einen stabförmigen Signalanschlusses (12A, 12B) ausgebildet ist.

6. Temperatursensor (10) nach einem der Ansprüche 1 bis 4, wobei der Träger (14) als vorgefertigtes Bauteil ausgebildet ist, wobei der zumindest eine stabförmige Signalanschluss (12A, 12B) durch Einstecken in die Rille (142) am Träger (14) festgelegt ist.

7. Temperatursensor (10) nach einem der Ansprüche 1 bis 6, wobei das von der Leiterplatte (18) abgewandte Ende (164) der Sensorleiterplatte (16) an einen Kühlkörper (20), einen mit dem Kühlkörper (20) thermisch gekoppelten Zwischenkörper oder eine Vergussmasse (22) des Inverters angebunden ist.

8. Temperatursensor (10) nach Anspruch 7, wobei das von der Leiterplatte (18) abgewandte Ende (164) der Sensorleiterplatte (16) derart in eine der Leiterplatte (18) gegenüberliegende Oberfläche (202) des Kühlkörpers (20), des Zwischenkörpers oder der Vergussmasse (22) eindringt, dass das Sensorelement (162) im Kühlkörper (20) oder in der Vergussmasse (22) aufgenommen ist.

9. Temperatursensor (10) nach Anspruch 7, wobei das von der Leiterplatte (18) abgewandte Ende (164) der Sensorleiterplatte (16) derart an eine der Leiterplatte (18) gegenüberliegenden Oberfläche (202) des Kühlkörpers (20), des Zwischenkörpers oder der Vergussmasse (22) derart angebunden ist, dass das Sensorelement (162) außerhalb des Kühlkörpers (20) oder der Vergussmasse (22) angeordnet ist.

10. Inverter (50), umfassend mehrere Halbleiterschaltelemente, ein Substrat, einen Kühlkörper (20) und eine Leiterplatte (18), wobei die Halbleiterschaltelemente auf dem Substrat angebracht sind, wobei das Substrat zwecks Entwärmung der Halbleiterschaltelemente an den Kühlkörper (20) oder einen am Kühlkörper (20) thermisch gekoppelten Zwischenkörper angebunden ist, wobei die Leiterplatte (18) elektronische Bauteile zur Ansteuerung der Halbleiterschaltelemente aufweist, wobei ein Temperatursensor (10) nach einem der Ansprüche 1 bis 9 an der Leiterplatte (18) befestigt ist.
